# EUROPEAN PATENT APPLICATION

(11) **EP 1 983 543 A1**
(43) Date of publication of application: **22.10.2008**
(21) Application number: 07008106.2
(22) Date of filing: 20.04.2007
(51) Int. Cl.: H01J 3/02, H01J 7/18, H01J 37/073

(54) **Gun chamber, charged particle beam apparatus and method of operating same**

(71) Applicant: ICT Integrated Circuit Testing Gesellschaft für Halbleiterprüftechnik mbH, 85551 Heimstetten (DE)
(72) Inventor: Adamec, Pavel, 85540 Haar (DE)
(74) Representative: Zimmermann, Gerd Heinrich

(57) **Abstract**

A gun chamber (100) for a charged particle emitter is provided, said gun chamber comprising at least one electrode (140, 200, 300) coated with a non-evaporable getter (NEG) material (150, 210, 310).

## Description

### FIELD OF THE INVENTION

The invention relates to a gun chamber, a charged particle beam apparatus utilizing said gun chamber and a method of operating the charged particle beam apparatus.

### BACKGROUND OF THE INVENTION

Technologies like microelectronics, micromechanics and biotechnology have created a high demand in industry for structuring and probing specimens within the nanometer scale. On such a small scale, probing or structuring, e.g. of photomasks, is often done with electron beams which are generated and focused in electron beam devices like electron microscopes or electron beam pattern generators. Electrons beams offer superior spatial resolution compared to e.g. photon beams due to their short wave lengths at a comparable particle energy.

The first step in the process of creating images in any electron microscope is the production of an electron beam. The electron beam is generated in a device often called an electron gun. Three major types of electron guns are used in electron microscopes: tungsten-hairpin filament guns, lanthanum-hexaboride guns, and field-emission guns. Field-emission guns offer several advantages over tungsten-hairpin filament guns or lanthanum-hexaboride guns: First, the brightness may be up to a thousand times greater than that of a tungsten gun. Second, the electrons are emitted from a point more narrow than that in the other sources. Thus, superior resolution is achieved by field-emission guns compared to tungsten or LaB₆ guns. Furthermore, the energy spread of the emitted electrons is only about one-tenth that of the tungsten-hairpin gun and one-fifth that of the LaB₆ gun. Finally, the field-emission gun has a very long life, up to a hundred times that of a tungsten gun. For these reasons, the field-emission gun is the preferred choice for a number of applications.

There exist three major types of field emission guns: cold field emission guns, thermal field emission guns and Schottky emitters. While cold field emission guns rely on the pure field emission effect, thermal field emission guns enhance the pure field emission effect by giving some thermal energy to the electrons in the metal, so that the required tunneling distance is shorter for successful escape from the surface. A Schottky emitter is a thermal field emitter that has been further enhanced by doping the surface of the emitter to reduce the work function.

The cold field emitter tip has the highest brightness of presently known emitters and is therefore the preferred choice for obtaining highest possible electron density in the smallest spot. Thus, electron microscopes equipped with cold cathode emitters are superbly suited to obtain high resolution, high quality images - especially at very low acceleration voltages. Extra advantages of cold emitters are their long lifetime and ease of use, which reduces the cost of ownership.

However, during operation continual adsorption and occasional desorption of residual gas molecules occurs on the emitting surface of cold field electron emitters. These adsorptions and desorptions lead to continuously degraded and momentarily instable emission current, respectively, so that the emitting surface has to be cleaned in regular intervals. Conventionally, this is done by a so-called "flashing" method. According to the flashing method, a heating current is supplied to the emitter so that the emitting surface heats up and the debris is removed from the surface. Heating the tip momentarily (flashing) can clean it, but new atoms and molecules quickly readsorb even in the best of vacuums. In addition, atoms may be ionized by the electron beam and subsequently accelerated back into the tip, causing physical sputtering of the tip itself. To minimize the current fluctuations, the electron source must be operated in a high vacuum environment.

Typically, the emitter chamber is pumped by an ion getter pump or a passive getter pump attached through the vacuum tubing. This configuration provides a sufficient pumping speed to achieve good average vacuum level in the emitter chamber. However, the relatively complicated configuration of the various internal parts within the emitter chamber may result in partially enclosed volumes which are only pumped at a considerably lower pumping speed. In addition, the dominant gas load in the emitter chamber is usually caused by electron stimulated desorption at internal parts. In particular, the extractor electrode or anode are illuminated by the electron beam and, therefore, are subject to electron stimulated desorption. As a result, the vacuum level near the emitter tip is considerably lower than the average vacuum level in the vacuum chamber. Therefore, the stability of the emission current is suboptimal.

It is therefore an object of the present invention to overcome at least partially the disadvantages associated with the prior art as they have been explained above.

### SUMMARY OF THE INVENTION

This object is solved by a gun chamber according to claim 1, a charged particle apparatus according to claim 16, the use of a non-evaporable getter coating material according to claim 19, and an operating method according to claim 24.

Further advantages, features, aspects and details of the invention are evident from the dependent claims, the description and the accompanying drawings.

According to a first aspect of the present invention a gun chamber for a charged particle emitter is provided. The gun chamber includes at least one electrode coated with a non-evaporable getter (NEG) material.

Due to the NEG coating near the emitter, the volume close to the emitter is directly pumped by the NEG coating. Thus, the pumping speed near the emitter is considerably increased. For example, typical pumping speeds of such NEG coatings are up to 10 1/s per square centimeter of the coating. In addition, the NEG coating blocks the diffusion of gas from the bulk of the electrode material. Thus, extreme ultra-high vacuum levels of 10⁻¹³ Torr or better can be achieved near the emitter. As a result, the contamination of the emitter tip is significantly reduced and the stability and quality of the emission current is improved.

According to an embodiment of the present invention, the NEG coating is applied to a surface of a suppressor electrode. According to another embodiment of the present invention, the NEG coating is applied to a surface of an extractor electrode. According to still another embodiment of the present invention, the NEG coating is applied to a surface of an on anode. Typically, the NEG coating is applied to a surface facing the emitter.

Especially the extractor electrode and the second anode, which is typically used in modem electron guns, are illuminated by the electron beam produced at the emitter tip. For example, up to 90% of the beam current is absorbed by the extractor electrode and about 99% of the beam current passing the extractor electrode is subsequently absorbed by the anode. Therefore, electron-stimulated desorption is very high at the electrode surfaces facing the emitter. Due to the NEG coating, the electron-stimulated desorption can be significantly reduced so that stability and quality of the emission current is further improved.

According to an exemplary embodiment of the present invention, the NEG coating has a thickness in the range from 1 µm to 20 µm. According to another exemplary embodiment of the present invention, the NEG coating includes at least one of the materials selected from the group consisting of Ti, V, Zr, Hf, Fe or any mixture thereof. According to one typical embodiment of the present invention, the NEG coating includes TiZrV or TiV alloy.

NEG coatings of the above-described types may undergo numerous cycles of repeated activation without losing their pumping capability. For example, such NEG coatings may undergo more than 50 activation/pump cycles without any noticeable deterioration of the pumping speed.

According to a further embodiment of the present invention, an overlayer including Pt, Pd or PdAg is disposed on the NEG coating. According to a typical embodiment of the present invention, the overlayer has a thickness in the range from 0.1 µm to 2 µm.

An overlayer of Pt, Pd or a PdAg alloy can improve the pumping speed for H₂ molecules. In particular, Pt, Pd or PdAg films have high sticking probabilities for H₂ molecules but only relatively low binding energies both fro surface adsorption and for solid solution. However, since the overlayer is coated on the NEG film the H₂ can migrate through the overlayer to the NEG film where it may be stored with a negligibly low dissociation pressure.

According to still another embodiment of the present invention, an activation temperature of the NEG coating is in the range from 120°C to 350°C. Typically, the activation temperature is in the range from 180°C to 250°C.

Such activation temperatures are comparatively low so that the NEG coating can be activated with conventional heaters for UHV apparatus. Furthermore, the lower activation temperature may allow using aluminum alloy for the chamber walls. Aluminum alloy may loose its integrity at higher temperatures but is advantageous in view of manufacturing costs.

According to a typical embodiment of the present invention, a heater is disposed adjacent said NEG coating. According to another typical embodiment of the present invention, the heater is integrally formed with the at least one electrode coated with the NEG coating material. Typically, the heater is adapted to heat the NEG coating to an activation temperature thereof.

According to a typical embodiment of the present invention, the emitter is a cold field emission gun.

According to another aspect of the present invention, a charged particle beam apparatus equipped with a gun chamber of the above described type is provided.

In such a charged particle beam apparatus, the volume close to the emitter is directly pumped by the NEG coating. Thus, the pumping speed near the emitter is considerably increased and the NEG coating blocks the diffusion of gas from the bulk of the electrode material. Thus, extreme ultra-high vacuum levels of 10⁻¹³ Torr or better can be achieved near the emitter. As a result, the contamination of the emitter tip is significantly reduced and the stability and quality of the emission current is improved. Accordingly, the imaging quality of the charged particle apparatus can be improved.

According to an embodiment of the present invention, the charged particle beam apparatus further includes an NEG coating applied to an inner wall of a vacuum chamber of the charged particle beam apparatus. Typically, the NEG coating on the inner wall is located in a portion of the vacuum chamber surrounding the gun chamber.

According to still another aspect of the present invention, a non-evaporable getter (NEG) coating material is used for at least partially coating an electrode of a cold field emission electron beam apparatus. According to typical embodiments of the present invention, this electrode may be a suppressor electrode of a cold field emitter and/or an extractor electrode of a cold field emitter and/or an anode of a cold field emitter. Furthermore, in exemplary embodiments of the present invention the thickness of the NEG coating is in the range from 1 µm to 20 µm. According to a further embodiment of the present invention, the NEG coating material comprises at least one of the materials selected from the group consisting of Ti, V, Zr, Hf, Fe or any mixture thereof.

According to a further aspect of the present invention, a method of operating a charged particle beam apparatus is provided. The method includes the steps of heating an NEG coating of at least one electrode comprised in a gun chamber of a charged particle beam apparatus; baking the NEG coating at a temperature greater than or equal to its activation temperature until the NEG coating is activated for pumping; pumping a region adjacent to the emitter of the charged particle beam apparatus utilizing the activated NEG coating. Typically, the baking is performed for 6 hrs to 50 hrs. According to a further embodiment of the present invention, the pumping is carried out until a vacuum level of 10⁻¹³ Torr or better is attained.

### BRIEF DESCRIPTION OF THE DRAWINGS

Some of the above indicated and other more detailed aspects of the invention will be described in the following description and partially illustrated with reference to the figures. Therein:
- Fig. 1: shows a schematic representation of a gun chamber according to an embodiment of the present invention.
- Fig. 2: shows a schematic representation of a gun chamber according to another embodiment of the present invention.
- Fig. 3: shows a schematic representation of a gun chamber according to still another embodiment of the present invention.
- Fig. 4: shows a schematic representation of a gun chamber according to a further embodiment of the present invention.
- Fig. 5: shows a schematic representation of a gun chamber according to an even further embodiment of the present invention.
- Fig. 6: shows a schematic representation of a gun chamber according to a different embodiment of the present invention.
- Fig. 7: shows a cross-sectional view of a coated electrode according to an embodiment of the present invention.
- Fig. 8: shows a cross-sectional view of a coated electrode with an integrated heater according to another embodiment of the present invention.
- Fig. 9: shows a schematic representation of a charged particle beam apparatus according to an embodiment of the present invention.

### DETAILED DESCRIPTION OF THE DRAWINGS

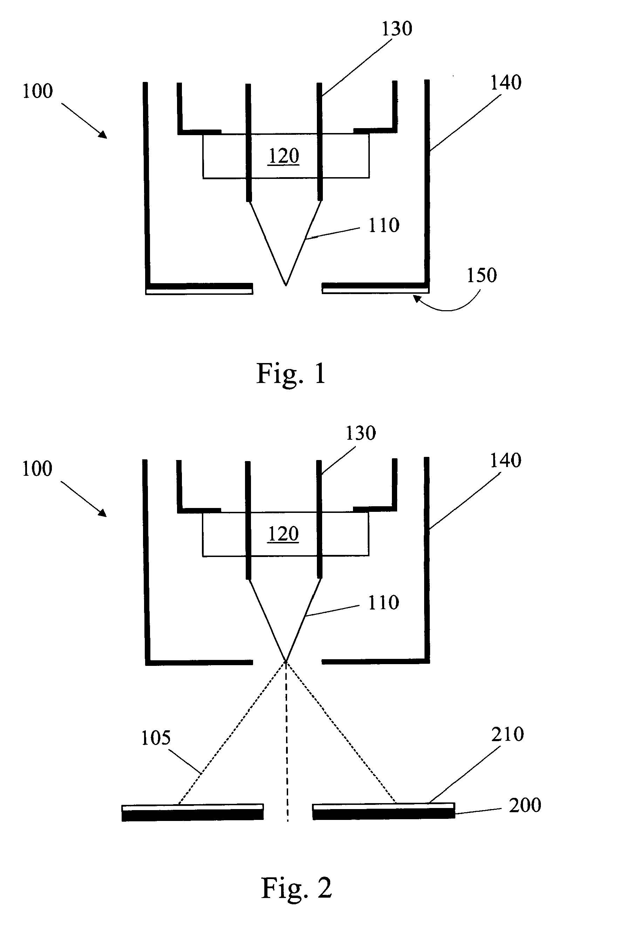

Fig. 1 shows a schematic representation of a gun chamber 100 according to an embodiment of the present invention. In the following, the present invention will be exemplified by means of a cold field emission gun. However, it will be understood by those skilled in the art that the present invention may also be executed with other types of emitters. Accordingly, the cold field emission gun should only be understood as a non-limiting example of emitters that may be used with the present invention. The gun chamber 100 includes a cold field emission gun 110 mounted on a support 120. Typically, support 120 is made of a ceramic material. Furthermore, electrical terminals 130 are connected to emitter tip 110 for supplying electrical current thereto. The electrical terminals 130 are fed through the insulating ceramic support 120. and are connected to a power source (not shown). Furthermore, the above described structure is housed inside a suppressor electrode 140, also sometimes referred to as a Wehnelt cap or cylinder.

According to the embodiment shown in Fig. 1, an outside surface of the suppressor electrode 140 is coated with a non-evaporable getter (NEG) material 150 around the central opening for the electron beam. In other words, the NEG coating 150 is applied adjacent to emitter 110. Typical NEG materials include at least one of the materials selected from the group consisting of Ti, V, Zr, Hf, Fe or any mixture thereof. Typical examples of NEG materials include TiZrV or TiV. Non-evaporable getter materials are available, e.g., from SAES Getters S.p.A., 20020 Lainate (Milano), Italy. Different from conventional ion getter pumps, the surface of the NEG coating is not sputtered during the pumping process so that no additional material is discharged. Therefore, risk of contaminating the emitter tip 110 is reduced compared to ion getter pumps. Furthermore, the activation temperatures of the NEG materials are considerably low, e.g., in the range from 120°C to 350°C, and more typically in the range from 180°C to 250°C. Typically, the NEG coating 150 has a thickness in the range from 1 µm to 20 µm, and more typically in the range from 4 µm to 10 µm. Such NEG coatings may undergo numerous cycles of repeated activation without losing their pumping capability. For example, a TiZrV film having a thickness of 5 µm may undergo more than 50 activation/pump cycles without any noticeable deterioration of the pumping speed.

The NEG coating 150 is located near emitter tip 110 so that the pumping capacity of coating 150 is provided adjacent the emitter tip. Accordingly, the volume close to the emitter is directly pumped by NEG coating 110. Thus, the pumping speed near the emitter is considerably increased. For example, typical pumping speeds of such NEG coatings are up to 10 1/s per square centimeter of the coating. In addition, the NEG coating blocks the diffusion of gas from the bulk of the suppressor material. Thus, extreme ultra-high vacuum levels of 10⁻¹³ Torr or better can be achieved near emitter tip 110. As a result, the contamination of the emitter tip is significantly reduced and the stability and quality of the emission current is improved.

Fig. 2 shows a schematic representation of a gun chamber according to another embodiment of the present invention. Therein, an extractor electrode 200 is provided in front of the emitter opening of the suppressor electrode 140. A surface of the extractor electrode 200 is coated with an NEG material 210 of the above described type. In particular, any of the above described features of the NEG coating 150 of suppressor electrode 140 may also be applied to the NEG coating 210 of extractor electrode 200. Furthermore, it will be understood that also the uncoated backside of extractor electrode 200 may be coated with NEG material. However, the NEG will typically be applied to a surface facing emitter tip 110 as will be explained in the following. During operation, an electron beam 105 emerging from emitter tip 110 impinges onto the surface of extractor electrode 200 which faces the emitter tip 110. Therefore, electron-stimulated desorption of contaminating molecules is likely to occur at this surface facing the emitter. For example, up to 90% of the beam current produced by emitter 110 may be collected by extractor electrode 200. Accordingly, the rate of electron-induced desorption will be very high at the illuminated portions of extractor electrode 200. Due to the NEG coating 210, the electron-stimulated desorption at extractor electrode 200 can be significantly reduced. Thus, the contamination of emitter 110 is reduced and stability and quality of the emission current can be improved.

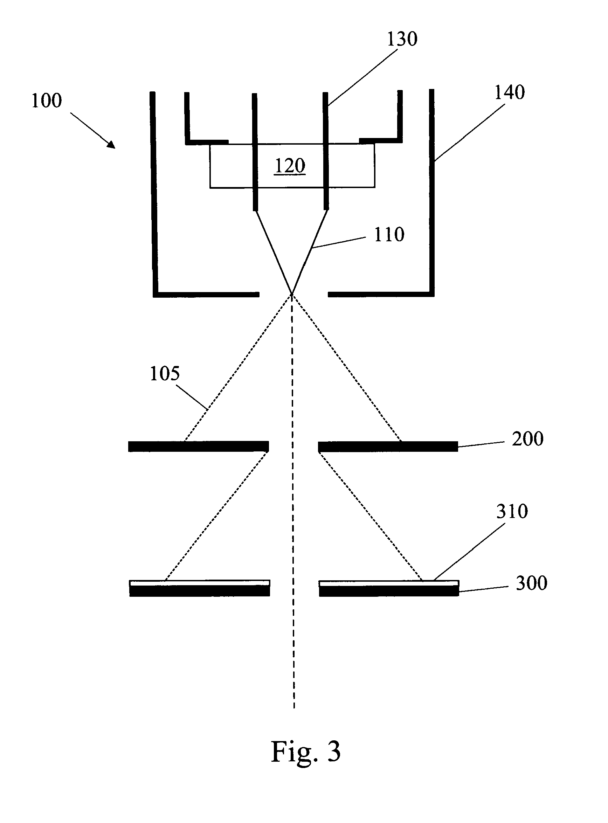

Fig. 3 shows a schematic representation of a gun chamber according to still another embodiment of the present invention. Therein, a second anode 300 is provided in addition to extractor electrode 200. Typically, second anode 300 is used for improving the controllability of the charged particle source 100. It should be understood that about 99% of the beam current passing the extractor electrode may be subsequently collected by the anode 300. Therefore, also anode 300 may exhibit a high rate of electron-induced desorption. However, in the embodiment shown in Fig. 3 an NEG coating 310 is applied to the surface of second anode 300 which faces emitter 110. Thus, similar effects as described above with respect to the extractor electrode can be obtained with the NEG coating 310 on anode 300. In particular, the electron-stimulated desorption at anode 300 can be significantly reduced so that the contamination of emitter 110 is reduced. As a result, stability and quality of the emission current produced by emitter 110 can be improved.

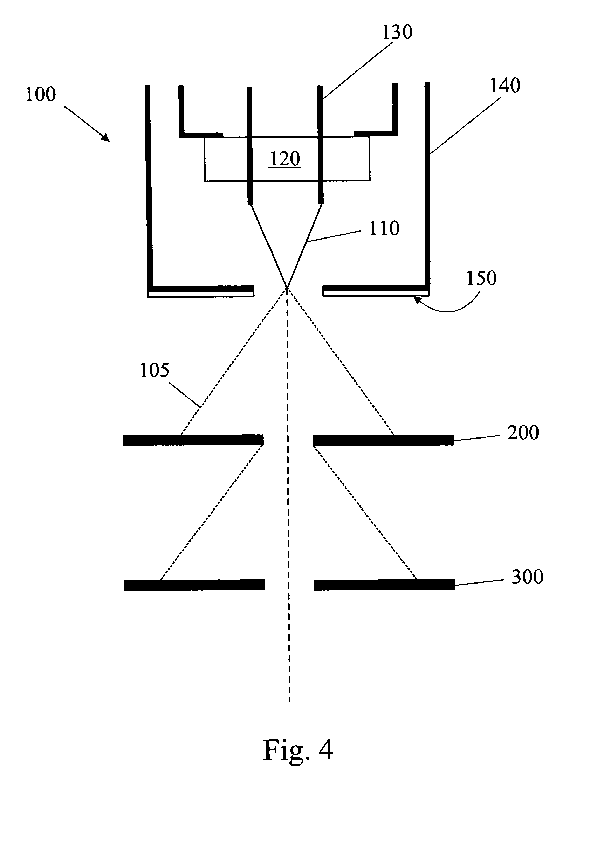

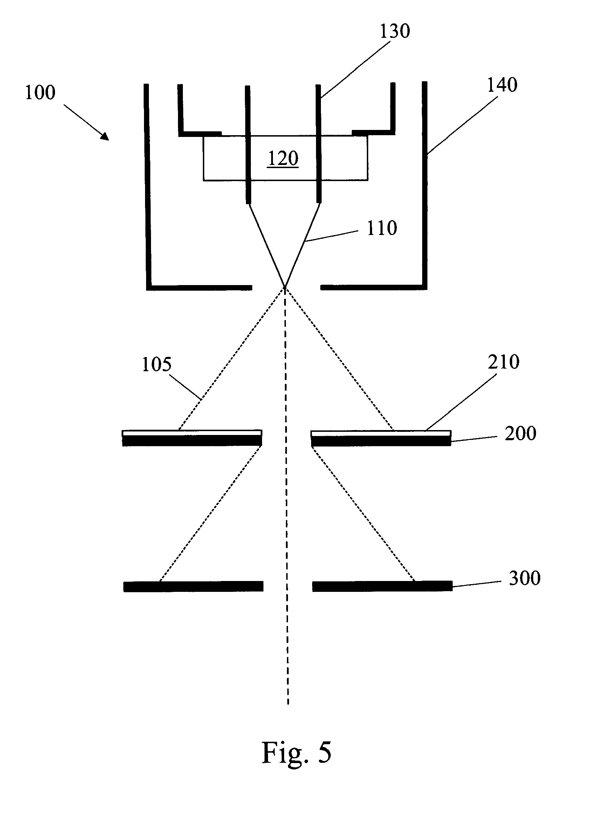

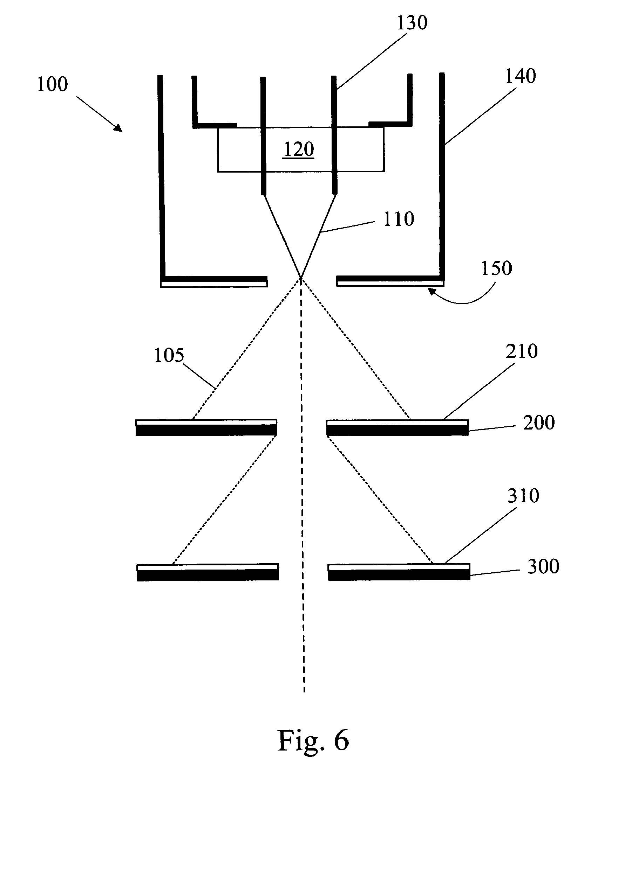

Fig. 4 to 6 show a schematic representations of gun chambers according to further embodiments of the present invention. In the embodiment shown in Fig. 4, an NEG coating 150 is applied to suppressor electrode 140 while extractor electrode 200 and anode 300 are uncoated. In the embodiment shown in Fig. 5, only extractor electrode 200 has an NEG coating 210 whereas in the embodiment of Fig. 6 all the electrodes within the gun chamber 100 are coated with NEG material. In other words, in the embodiment shown in Fig. 6 the suppressor electrode 140, extractor electrode 200, and anode 300 have coatings 150, 210, 310 made of a non-evaporable getter material of the above-described types. It will be understood by those skilled in the art that any combination of NEG coatings applied to the suppressor electrode 140 and/or the extractor electrode 200 and/or the anode 300 may be used in accordance with the specific requirements of an application.

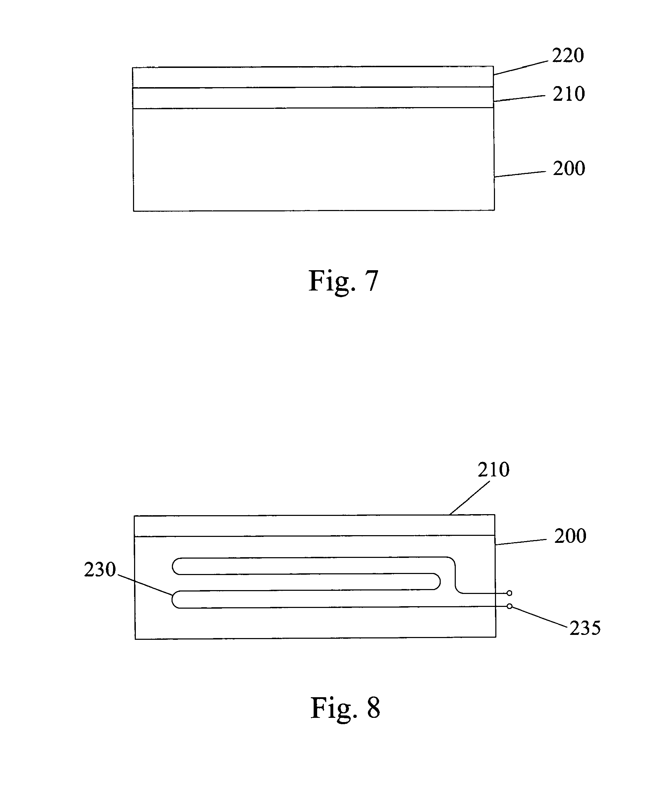

Fig. 7 shows a cross-sectional view of a coated electrode 200 according to an embodiment of the present invention. Therein, it is shown that a surface of electrode 200 is coated with an NEG material 210 as described above. Further to the NEG coating 210, an overlayer 220 is coated onto the NEG film 210. Overlayer 220 includes Pt, Pd or PdAg alloy and may even consist completely of one of those materials. An overlayer made of Pt, Pd or a PdAg alloy can improve the pumping speed for H₂ molecules. In particular, Pt, Pd or PdAg films have high sticking probabilities for H₂ molecules but only relatively low binding energies both for surface adsorption and for solid solution. However, since the overlayer 220 is coated on the NEG film the H₂ can migrate through overlayer 220 to the NEG film 210 where it may be stored with a negligibly low dissociation pressure. In this context, overlayers made from PdAg alloy may be particularly useful for improving the pumping speed for H₂ molecules. For example, an alloy including 70% Pd and 30% Ag may be applied for the coating. A layer system of Pd₇₀Ag₃₀/NEG may provide easier transmission of H₂ to the underlying NEG 210 than a pure Pd film. Typically, the overlayer 220 has a thickness in the range from 0.1 µm to 2 µm.

Fig. 8 shows a cross-sectional view of a coated electrode 200 with an integrated heater 230 according to another embodiment of the present invention. Heater 230 is integrally formed with electrode 200 having an NEG coating 210. Thus, heater 230 is disposed adjacent the NEG coating 210 so that it can provide effective heating thereof. In the embodiment shown in Fig. 8, heater 230 is an electrical resistance heater. Accordingly, electrical terminals 235 are provided to supply electric power to heater 230. However, it will be understood by those skilled in the art that also other types of heaters may be used if applicable. The heater 230 is adapted to heat the NEG coating 210 to its activation temperature, i.e. typically to temperatures in the range from 120°C to 350°C. Thus, activation of NEG coating 210 is facilitated by heater 230. However, it will be understood by those skilled in the art that also conventional heaters for ultra-high vacuum apparatus may be used to activate the NEG coatings 150, 210, 310 in the absence of integrated heaters 230.

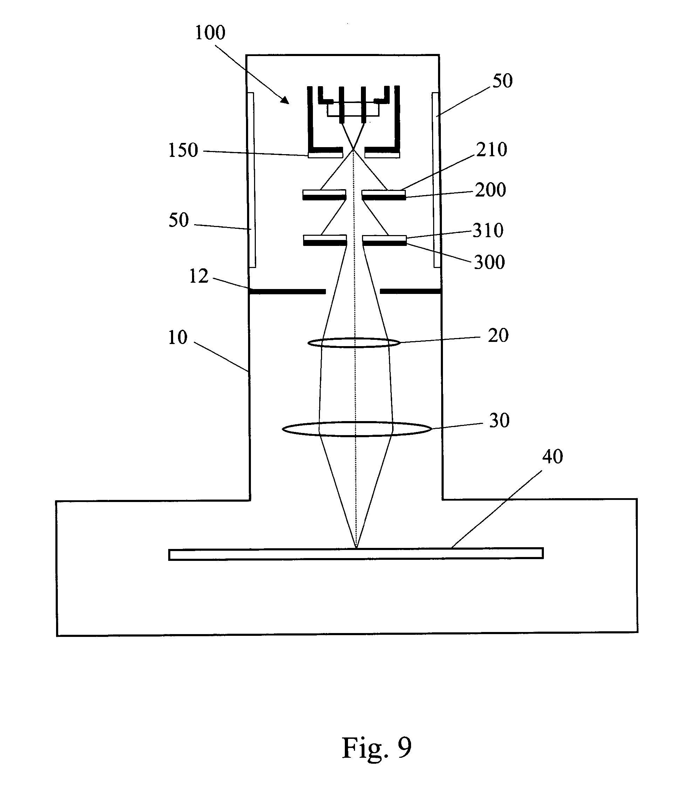

Fig. 9 shows a schematic representation of a charged particle beam apparatus according to an embodiment of the present invention. Therein, the charged particle beam apparatus includes a vacuum chamber 10 in which a gun chamber 100, a condenser lens 20 and an objective lens 30 are provided. Thus, the charged particle beam apparatus is adapted to focus a beam of charged particles onto the surface of a specimen 40. As can be seen, the upper part of the apparatus is separated from the lower part by an aperture 12. Thus, differential pressure pumping is enabled. This technique is known in the art and will therefore not be explained in more detail. The gun chamber 100 is of the configuration as described with regard to the embodiment shown in Fig. 6. Therefore, a more detailed explanation of gun chamber 100 is omitted. The charged particle beam apparatus further includes an NEG coating 50 according to one of the configurations described above. NEG coating 50 is applied to an inner wall of a vacuum chamber 10 of the charged particle beam apparatus. Thus, additional pumping capacity is provided within vacuum chamber 10 and diffusion of gas from the bulk of the chamber wall is blocked. According to a typical embodiment, the NEG coating 50 is located in a portion of the vacuum chamber 10 which surrounds gun chamber 100. Thus, the pumping capacity in the vicinity of emitter 110 is enhanced so that the vacuum level at the emitter tip can be improved. It will be understood by those skilled in the art that also NEG coating 50 applied to the chamber wall may be coated with an overlayer of Pt, Pd or PdAg alloy.

Next, a method aspect of the present invention is explained. Therefore, one should know that NEG materials have to be activated to exhibit sufficient pumping capacity. In order to activate the NEG material, it must be heated to at least its activation temperature which is typically in the range from 120°C to 350°C. Therefore, a method of operating a charged particle beam apparatus according to the above-described configuration includes the steps of heating an NEG coating of at least one electrode comprised in a gun chamber of the charged particle beam apparatus; baking the NEG coating at a temperature greater than or equal to its activation temperature until the NEG coating is activated for pumping; and pumping a region adjacent to the emitter of the charged particle beam apparatus with the activated NEG coating. Typically, the baking step is performed for 6 hrs to 50 hrs. For example, sufficient results have been obtained for a Pd₇₀Ag₃₀/NEG system with about 24 hrs baking at 250°C. The pressure measured after the bakeout was 2 x 10⁻¹³ Torr.

Having thus described the invention in detail, it should be apparent for a person skilled in the art that various modifications can be made in the present invention without departing from the spirit and scope of the following claims.

## Claims

1. A gun chamber (100) for a charged particle emitter comprising at least one electrode (140, 200, 300) coated with a non-evaporable getter (NEG) material (150, 210, 310).

2. The gun chamber according to claim 1, wherein the NEG coating (150) is applied to a surface of a suppressor electrode (140).

3. The gun chamber according to claim 1 or 2, wherein the NEG coating (210) is applied to a surface of an extractor electrode (200).

4. The gun chamber according to any of the preceding claims, wherein the NEG coating (310) is applied to a surface of an on anode (300).

5. The gun chamber according to claim 3 or 4, wherein the NEG coating (210, 310) is applied to a surface facing an emitter (110).

6. The gun chamber according to any of the preceding claims, wherein the NEG coating (150, 210, 310) has a thickness in the range from 1 µm to 20 µm.

7. The gun chamber according to any of the preceding claims, wherein the NEG coating comprises at least one of the materials selected from the group consisting of Ti, V, Zr, Hf, Fe or any mixture thereof.

8. The gun chamber according to claim 7, wherein the NEG coating comprises TiZrV or TiV.

9. The gun chamber according to any of the preceding claims, further comprising an overlayer (220) comprising Pt, Pd or PdAg and disposed on the NEG coating (220).

10. The gun chamber according to claim 7, wherein said overlayer (220) has a thickness in the range from 0.1 µm to 2 µm.

11. The gun chamber according to any of the preceding claims, wherein an activation temperature of the coating is in the range from 120°C to 350°C.

12. The gun chamber according to any of the preceding claims, further comprising heater (230) disposed adjacent said NEG coating.

13. The gun chamber according to claim 12, wherein the heater (230) is integrally formed with said at least one electrode (140, 200, 300) having said NEG coating (150, 210, 310).

14. The gun chamber according to claim 12 or 13, wherein said heater (230) is adapted to heat said NEG coating (150, 210, 310) to an activation temperature of said NEG coating.

15. The gun chamber according to any of the preceding claims, wherein the emitter (110) is a cold field emission gun.

16. A charged particle beam apparatus comprising a gun chamber according to any of the preceding claims.

17. The charged particle beam apparatus according to claim 16, further comprising an NEG coating (50) applied to an inner wall of a vacuum chamber (10) of said charged particle beam apparatus.

18. The charged particle beam apparatus according to claim 17, wherein said NEG coating is located in a portion of the vacuum chamber (10) surrounding a gun chamber.

19. A use of a non-evaporable getter (NEG) coating material for at least partially coating an electrode of a cold field emission electron beam apparatus.

20. The use according to claim 19, wherein said electrode is a suppressor electrode (140) of a cold field emitter and/or an extractor electrode (200) of a cold field emitter and/or an anode (300) of a cold field emitter.

21. The use according to claim 19 or 20, wherein said NEG coating has a thickness in the range from 1 µm to 20 µm.

22. The use according to any of claims 19 to 21, wherein said NEG coating material comprises at least one of the materials selected from the group consisting of Ti, V, Zr, Hf, Fe or any mixture thereof.

23. The use according to any of claims 19 to 22, further comprising an overlayer comprising Pt, Pd or PdAg and disposed on the NEG coating.

24. A method of operating a charged particle beam apparatus according to any of claims 16 to 18, comprising the steps of:
(a) heating an NEG coating of at least one electrode comprised in a gun chamber of said charged particle beam apparatus;
(b) baking said NEG coating at a temperature greater than or equal to its activation temperature until said NEG coating is activated for pumping;
(c) pumping a region adjacent to an emitter of said charged particle beam apparatus with said activated NEG coating.

25. The method according to claim 24, wherein the activation temperature of said NEG coating is in the range from 120°C to 350°C.

26. The method according to claim 24 or 25, wherein the baking in step (b) is performed for 6 hrs to 50 hrs.
